# EUROPEAN PATENT APPLICATION

(11) **EP 0 621 644 A2**
(43) Date of publication of application: **26.10.1994**
(21) Application number: 94104575.9
(22) Date of filing: 23.03.1994
(51) Int. Cl.: H01L 29/784, H01L 21/336

(54) **Semiconductor-on-insulator field-effect transistor**

(30) Priority: 23.04.1993 US 52351
(71) Applicant: International Business Machines Corporation, Armonk, N.Y. 10504 (US)
(72) Inventor: Chang, Wen Hsing, Wappinger Falls, New York 12590 (US); Wang, Li-Kong, Montvale, New Jersey 07645 (US)
(74) Representative: Schäfer, Wolfgang, Dipl.-Ing.

(57) **Abstract**

A semiconductor device, comprising: a base substrate of semiconductor material; a layer of insulating material over the substrate; an active layer of semiconductor material over the layer of insulating material; a transistor including source, channel and drain regions formed in the active layer, the source and drain regions being of a first conductivity type spaced by the channel region of a second conductivity type, the transistor further including a gate electrode spaced from the channel region; and, the base substrate including a mesa region extending into the layer of insulating material underneath of the channel region, whereby the base substrate is in generally closer proximity to the channel region than to the source and drain regions.

## Description

### Field of the Invention

The present invention relates generally to semiconductor devices and more particularly to a field-effect transistor formed in a semiconductor-over-insulator structure.

### Background of the Invention

In order to increase isolation and improve operating characteristics, it is known in the art to fabricate semiconductor devices in what is commonly termed a "semiconductor-over-insulator" (SOI) structure.

In conventional, bulk-silicon semiconductor device structures, devices such as bipolar and field-effect transistors (FET) are fabricated directly in the silicon (or other semiconductor) substrate/wafer. Device isolation is accomplished using a variety of techniques, such as doped regions, buried layers, insulator-filled trenches, and combinations of these structures. These isolation structures are often complex to form, space-consuming, and provide less than desirable isolation characteristics.

In an SOI structure, semiconductor devices are formed in a typically thin, active layer of semiconductor material, the semiconductor material being formed directly on a layer of insulating material. The insulating material may in turn be formed over a bulk, base substrate of semiconductor material. This SOI structure, with the integral layer of insulating material, yields a final device structure having a desirably high level of device isolation. This isolation is typically achieved in a less complex and more compact manner than the previously described bulk-silicon isolation techniques.

The present inventors have determined that, for FETs fabricated in a conventional SOI structure, the short-channel, threshold voltage roll-off of a fully-depleted, thin-film device is worse than that of similar devices formed in conventional, bulk-semiconductor material. Thus, FET devices formed in a conventional SOI environment cannot take full advantage of the benefits typically afforded by the SOI structure.

### Objects of the Invention

One object of the present invention is to provide a new and improved FET structure.

A more particular object of the present invention is to provide such an FET structure implemented in an SOI environment.

Another object of the present invention is to provide such an FET structure having an improved short-channel, threshold voltage roll-off, and decreased source-channel and drain-channel leakage currents.

### Summary of the Invention

In accordance with one aspect of the present invention, there is provided a semiconductor device, comprising: a base substrate of semiconductor material; a layer of insulating material over the substrate; an active layer of semiconductor material over the layer of insulating material; a transistor including source, channel and drain regions formed in the active layer, the source and drain regions being of a first conductivity type spaced by the channel region of a second conductivity type, the transistor further including a gate electrode spaced from the channel region; and, the base substrate including a mesa region extending into the layer of insulating material underneath of the channel region, whereby the base substrate is in generally closer proximity to the channel region than to the source and drain regions.

In operation, the mesa region functions as a means for moving the electrical potential of the base substrate into close proximity with the transistor channel region. This has the effect of shielding the channel region from electrical field(s) generated when applying a potential at the source and/or drain regions. This shielding effect minimizes the short-channel, threshold voltage roll-off otherwise caused by these electrical fields.

In accordance with another aspect of the present invention, there is provided a method of manufacturing a semiconductor device comprising the steps of: providing a base substrate of semiconductor material, the substrate having a patterned surface including at least one mesa bounded by trenches; forming a layer of insulating material over the substrate surface such that the insulating material fills the trenches and forms a thin layer over the upper surface of the mesa; forming an active layer of semiconductor material over the layer of insulating material; and forming an FET including source and drain regions of a first conductivity type over the trenches, a channel region of a second conductivity type intermediate the source and drain regions over the mesa, and a conductive gate region overlying and spaced from the channel region; whereby the base substrate mesa extends into closer proximity to the channel region than to the source and drain regions.

### Brief Description of the Figures

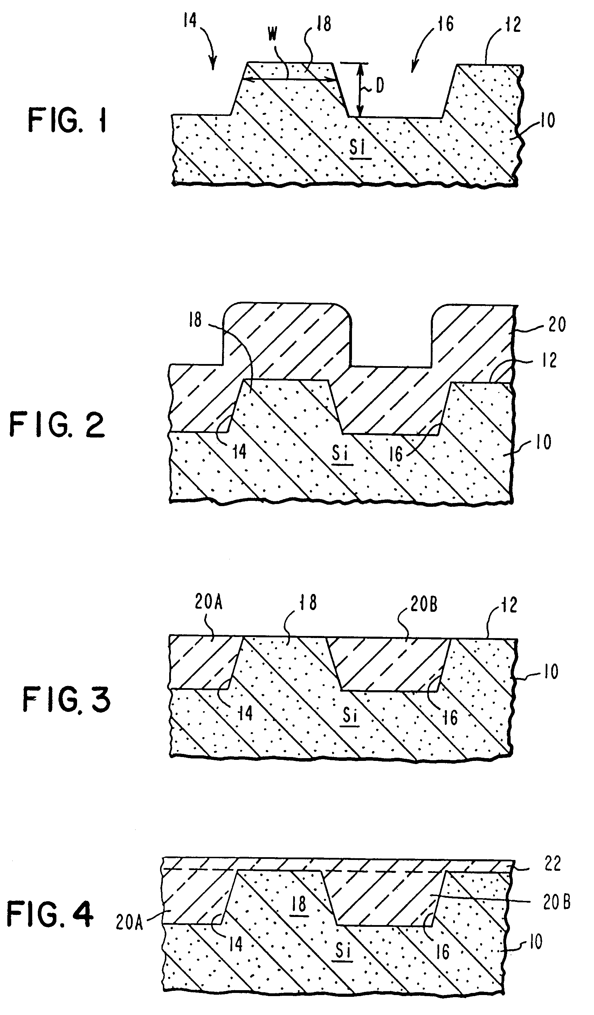

These and other objects, features, and advantages of the present invention will become apparent upon consideration of the following Description of the Invention considered with the drawing Figures, in which Figs. 1-7 are cross-sectional views illustrating consecutive steps in manufacturing an FET in accordance with the present invention.

### Description of the Invention

Referring now to the drawings, Fig. 1 shows a conventional semiconductor substrate 10, for example N-doped, crystalline silicon (Si) having a crystallographic orientation of 〈100〉. The upper surface 12 of substrate 10 has been patterned to provide a raised mesa 18 bounded by trenches 14, 16. This patterning is done using conventional photo-lithographic masking and etching techniques, and is repeated across the regions of surface 12 whereat it is desired to form FET devices of the type described herein.

In the present embodiment of the invention, trenches 14, 16 are formed to a depth **D** in the range of 300 nanometers (nm)-1 micron, and mesa 18 is formed to a width **W** in the range of 300nm-2 microns. In the present example, both **D** and **W** are selected to be 500nm.

Referring now to Fig. 2, a layer 20 of silicon dioxide (SiO₂) is formed conformally over surface 12 of substrate 10 to a thickness greater than depth **D** of trenches 14, 16, the thickness preferably being approximately twice depth **D**. Oxide layer 20 is formed by a conventional CVD process, the resulting layer filling trenches 14, 16 to a height greater than that of mesa 18.

With reference now to Fig. 3, the upper surface of oxide layer 20 is polished downward, stopping on surface 12 of substrate 10. Accomplished by conventional chemical-mechanical (chemmech) polishing, this process step leaves the upper surface of mesa 18 exposed, and trenches 14, 16 filled with remaining portions 20A, 20B of oxide layer 20. The structure is subsequently exposed to a steam environment to grow, by thermal oxidation, a thin layer 22 of SiO₂ over the upper surface of oxide regions 20A, 20B, and mesa 18. Layer 22 is grown to a thickness in the range of 10nm-100nm, selected to be 20nm in the present example. The structure including oxide layer 22 is shown in Fig. 4.

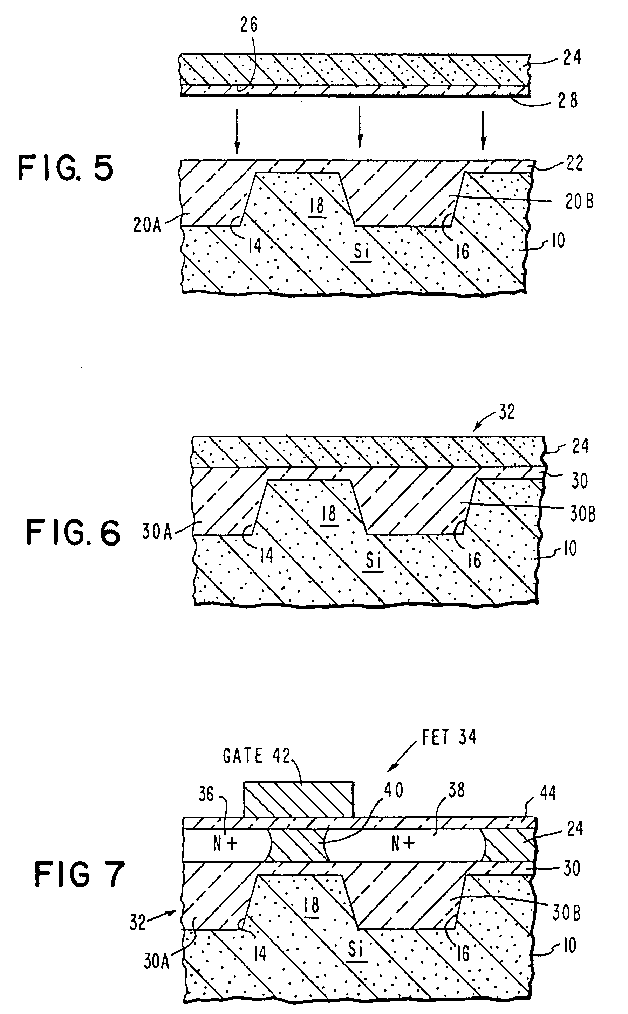

Referring now to Fig. 5, there is provided a second substrate 24 of silicon having a planar surface 26. Substrate 24 comprises P-doped crystalline silicon having a crystallographic orientation of 〈100〉. A conformal layer 28 of SiO₂, having a thickness in the range of 10nm-100nm, is situated on surface 26 of substrate 24. In the present example, the thickness of layer 28 is selected to be 50nm. Oxide layer 28 is formed, for example, by a conventional process of thermal oxidation, or CVD deposition.

Referring now to Fig. 6, wafer 24 is bonded to wafer 10 via the bonding of oxide layers 28, 22. This bonding is accomplished by mechanically pressing the surfaces of oxide layers 22, 28 together and annealing, in a known manner. See, for example, Gotou, H. et al., "SOI-Device on Bonded Wafer," Fujitsu Sci. Tech. J., 24, 4, pp. 408-417 (December 1988), for a description of various known types of pressure bonding.

Still with reference to Fig. 6, for practical purposes, the various oxide regions and layers described above become substantially indistinguishable from one-another, and are henceforth indicated as oxide layer 30. The regions of oxide layer 30 contained in trenches 14, 16 are indicated as 30A, 30B, respectively. In the SOI structure 32 thus shown in Fig. 6, substrate 10 is to function as what is commonly termed the "base substrate", while substrate 24 is to function as the "active substrate".

With reference now to Fig. 7, an N-channel FET 34 is formed in the active substrate 24 of SOI structure 32. FET 34 includes N+ doped source and drain regions 36, 38, positioned over oxide-filled trenches 14, 16, respectively. Source region 36 and drain region 38 are spaced apart by a thin, P-doped channel region 40 formed over the upper surface of mesa 18. A conductive gate region 42 is positioned overlying channel region 40 and spaced therefrom by a layer or stack of insulating materials 44 such as SiO₂ and/or silicon nitride (Si₃N₄).

Source 36, drain 38, and channel region 40 of FET 34 are formed in a conventional manner by masking and doping of active substrate 24. The various dimensions, described above, are sufficiently large so as to create no substantial alignment problems. Further, the difference in the index of refractions in SOI structure 32 between mesa region 18 and trench regions 14, 16, is sufficiently large that it can be used as a fiducial for the placement of etching and deposition masks.

Insulator 44 and gate 42 are similarly formed in a conventional manner to complete FET 34.

In accordance with the present invention, FET 34 has been fabricated such that base substrate 10 underlies and extends closer to channel 40, than to source and drain regions 36, 38. Source region 36 is substantially spaced from base substrate 10 by oxide-filled trench 14, while drain region 38 is similarly spaced from the base substrate by oxide-filled trench 16.

The present inventors have discovered that the close proximity of base substrate 10 to channel region 40 shields the channel region from, and reduces the influence of, the source and drain voltages, thus improving the short-channel, threshold voltage roll-off of FET 34.

The benefit of the present invention is achieved by moving the potential of base substrate 10 into close proximity with channel region 40, such that the electrical fields which arise when potentials are applied to the source and/or drain regions are inhibited from penetrating into the short channel region. These electrical fields would otherwise worsen the short-channel, threshold voltage roll-off of FET 34.

In the embodiment described above, the potential of base substrate 10 is placed proximate channel region 40 through the positioning of base substrate mesa 18 underneath of channel region 40. However, it will be understood that other readily apparent structures can accomplish the same effect. For example, conductive, charge-carrying mesas such as mesas 18 can be formed on the base substrate through the deposition of a conductive material, or layers of conductive materials. Any structure which conducts a charge so as to move the potential of the base substrate into close proximity with the channel region, shielding the channel region from the undesirable effects of the electrical fields, is contemplated by the present invention and will achieve the effects of the present invention.

There is thus provided a new and improved FET structure, fabricated in an SOI environment, and including a channel region positioned over a raised, base substrate mesa so as to place the base substrate in closer proximity to the channel region than to the source and drain regions. The resulting FET has improved operating characteristics relative to FETs formed in a conventional SOI environment having a uniform-thickness, buried insulating layer. The invention has application in manufacturing FET devices in large scale integrated and very large scale integrated circuit structures.

## Claims

1. A semiconductor device, comprising:
a base substrate of semiconductor material;
a layer of insulating material over said base substrate;
an active layer of semiconductor material over said layer of insulating material;
a transistor including source, channel and drain regions formed in said active layer, said source and drain regions being of a first conductivity type spaced by said channel region of a second conductivity type, said transistor further including a gate electrode spaced from said channel region; and
said base substrate including a mesa region extending into said layer of insulating material underneath of said channel region, whereby said base substrate is in generally closer proximity to said channel region than to said source and drain regions.

2. The semiconductor device in accordance with claim 1 wherein said base substrate comprises silicon and doped silicon.

3. The semiconductor device in accordance with claim 1 or 2 wherein said insulating material comprises silicon dioxide.

4. The semiconductor device in accordance with any one of the claims 1 to 3 wherein said active layer comprises silicon and doped silicon.

5. The semiconductor device in accordance with any one of the claims 1 to 4 wherein said layer of insulating material has a thickness in the range of 10nm-100nm underneath of said channel region and a thickness in the range of 300nm-1 micron underneath of said source and drain regions.

6. The semiconductor device in accordance with any one of the claims 1 to 5 wherein said channel has a length of about 500 nm between said source and drain regions.

7. A method of manufacturing a semiconductor device comprising the steps of:
providing a base substrate of semiconductor material, said base substrate having a patterned surface including at least one mesa bounded by trenches;
forming a layer of insulating material over said substrate surface such that said insulating material fills said trenches and forms a thin layer over the upper surface of said mesa;
forming an active layer of semiconductor material over said layer of insulating material; and
forming an FET including source and drain regions of a first conductivity type over said trenches, a channel region of a second conductivity type intermediate said source and drain regions over said mesa, and a conductive gate region overlying and spaced from said channel region;
whereby said base substrate mesa extends into closer proximity to said channel region than to said source and drain regions.

8. A semiconductor device, comprising:
a base substrate of semiconductor material;
a layer of insulating material over said base substrate;
an active layer of semiconductor material over said layer of insulating material;
a transistor including source, channel and drain regions formed in said active layer, said source and drain regions being of a first conductivity type spaced by said channel region of a second conductivity type, said transistor further including a gate electrode spaced from said channel region; and
means electrically connected to said base substrate for moving the electrical potential of said base substrate into close proximity with said channel region.

9. The semiconductor device in accordance with claim 8 wherein said means includes a mesa region extending from said base substrate into said layer of insulating material underneath of said channel region, whereby said base substrate potential is in generally closer proximity to said channel region than to said source and drain regions.

10. The semiconductor device in accordance with claim 9 wherein said mesa region comprises an extension of said base substrate and an electrically conductive layer formed on said base substrate.
